# EUROPÄISCHE PATENTSCHRIFT

(11) **EP 3 151 321 B1**
(45) Veröffentlichungstag und Bekanntmachung des Hinweises auf die Patenterteilung: **24.07.2019**
(21) Anmeldenummer: 15187624.0
(22) Anmeldetag: 30.09.2015
(51) Int. Cl.: G01R 31/36, H01M 8/0444, H01M 8/04492, H01M 8/04537, H01M 8/1018

(54) **VERFAHREN UND VORRICHTUNG ZUR ÜBERWACHUNG EINES LAGERUNGSZUSTANDES EINER BRENNSTOFFZELLE ODER EINES BRENNSTOFFZELLENSTAPELS**
METHOD AND DEVICE FOR MONITORING A STORAGE STATE OF A FUEL CELL OR A FUEL CELL STACK
PROCEDE ET DISPOSITIF DE REGLAGE DESTINES A LA SURVEILLANCE D'UN ETAT DE CHARGE D'UNE CELLULE DE COMBUSTIBLE OU D'UNE PILE DE CELLULES COMBUSTIBLES

(43) Veröffentlichungstag der Anmeldung: 05.04.2017
(73) Patentinhaber: Siemens Aktiengesellschaft, 80333 München (DE)
(72) Erfinder: Brandt, Torsten, 91301 Forchheim (DE)

(56) Entgegenhaltungen:
- EP-A1- 1 898 483
- EP-A1- 2 629 109
- DE-A1-102014 018 197
- US-A1- 2006 074 574

## Beschreibung

Die Erfindung betrifft ein Verfahren und eine Vorrichtung zur Überwachung eines Lagerungszustandes einer Brennstoffzelle oder eines Brennstoffzellenstapels gemäß Patentanspruch 1 bzw. Patentanspruch 7, sowie Überwachungssysteme gemäß den Ansprüchen 8 und 9.

In einer Brennstoffzelle wird durch die elektrochemische Verbindung von Wasserstoff (H₂) und Sauerstoff (O₂) an einer Elektrode zu Wasser (H₂O) elektrischer Strom mit hohem Wirkungsgrad erzeugt. Die technische Umsetzung dieses Prinzips der Brennstoffzelle hat zu unterschiedlichen Lösungen, und zwar mit verschiedenen Elektrolyten und Betriebstemperaturen zwischen 60°C und 1.000°C geführt.

Die Brennstoffzellen werden während ihres Betriebs mit Betriebsgasen - also einem wasserstoffhaltigen Brenngas und einem sauerstoffhaltigen Oxidationsgas - versorgt. Eine Brennstoffzelle umfasst dabei üblicherweise einen ionendurchlässigen Elektrolyten und zu beiden Seiten jeweils eine Katalysatorschicht und eine Elektrode.

In Fall von Polymer-Elektrolyt-Membran-Brennstoffzellen (PEM-Brennstoffzellen) ist der Elektrolyt eine protonenleitende Membran. Diese Membran bildet zusammen mit der Katalysatorschicht und den Elektroden eine Membran-Elektrodeneinheit. Daran schließt sich zu beiden Seiten jeweils ein Gasraum für das Brenngas bzw. das Oxidationsgas an.

Es ist bereits aus der DE 10 2013 226 823 A1, der
EP 1 646 101 B1 und der WO 03/098769 A2 bekannt, den Betriebszustand von Brennstoffzellen im laufenden Betrieb (d.h. bei der Versorgung einer angeschlossenen Last mit Strom) zu überwachen, indem eine Impedanz der Brennstoffzellen ermittelt wird. Hierzu wird dem Betriebsstrom ein sinusförmiger Messstrom überlagert. Aus der Impedanz wird dann auf den Betriebszustand bzw. auf Fehler in den Brennstoffzellen geschlossen.

Aus der EP 1 898 483 A1 ist ein Brennstoffzellensystem bekannt, bei dem während des Betriebs einer Brennstoffzelle mit einer Messeinrichtung die Impedanzen der Brennstoffzelle bei einer höheren und einer niedrigeren Frequenz gemessen werden, und bei dem mit einer Beurteilungseinrichtung ein Versorgungszustand des Brenngases bezüglich der Brennstoffzelle und ein Feuchtigkeitszustand des Elektrolyten der Brennstoffzelle basierend auf einer Kombination des Messergebnisses der Impedanz bei der niedrigeren Frequenz und des Messergebnisses der Impedanz bei der höheren Frequenz beurteilt werden.

In der DE 10 2014 018 197 A1 ist ein Verfahren und eine Vorrichtung zum Ermitteln der Impedanz eines Brennstoffzellenstapels bei dessen regulärem Betrieb offenbart, wobei die Impedanz bei einer niedrigeren und einer höheren Frequenz bestimmt wird. Bei der niedrigeren Frequenz kann die Stöchiometrie der beiden Reaktanden und bei der höheren Frequenz kann die Membranfeuchte bestimmt werden.

Häufig kommen Brennstoffzellen nach deren Herstellung und einem nachfolgenden Test noch nicht gleich zum Einsatz, sondern müssen beim Hersteller und/oder bei einem Abnehmer der Brennstoffzellen zwischengelagert werden. Insbesondere gilt dies für Ersatz- oder Austauschbrennstoffzellen, die zur Sicherstellung einer hohen Verfügbarkeit einer Brennstoffzellenanlage für den Fall eines Ausfalls von Brennstoffzellen und eines notwendiges Austauschen vorgehalten werden. Unter einer Lagerung wird hierbei ein Zustand verstanden, bei dem die Brennstoffzellen nicht betrieben werden können, d.h. es können ihnen keine Reaktanden zugeführt werden. Entsprechend sind die Brennstoffzellen auch nicht an Versorgungseinrichtungen für die Reaktanden angeschlossen. Üblicherweise sind die elektrischen Lastanschlüsse derartiger Brennstoffzellen kurzgeschlossen, um eine Potenzialdifferenz zwischen der Kathode und der Anode der Brennstoffzelle zu verhindern. Außerdem sind die Gasräume derart mit Wasserstoff befüllt, dass einem durch Leckagen und Undichtigkeiten eindringendem Sauerstoff stets ein stöchiometrischer Überschuss an Wasserstoff gegenübersteht, um Korrosionen und Oxidationen in der Brennstoffzelle und deren Bauelementen zu verhindern. Dieser Wasserstoff-Überschuss wird beispielsweise beim Hersteller der Brennstoffzellen bei einem Abschalten der Brennstoffzellen in einem Testbetrieb erzeugt (siehe z.B. EP 0 914 685 B1).

Bei der Lagerung der Brennstoffzellen ist somit sicherzustellen, dass in den Gasräumen stets ein Wasserstoffüberschuss vorliegt. Außerdem ist sicherzustellen, dass der Elektrolyt (im Fall von PEM-Brennstoffzellen die Elektrolyt-Membran) nicht austrocknet.

Es ist deshalb Aufgabe vorliegende Erfindung, ein Verfahren und eine Vorrichtung anzugeben, mit denen diese beiden Anforderungen erfüllt werden können.

Die Lösung der auf das Verfahren gerichteten Aufgabe gelingt durch ein Verfahren gemäß Patentanspruch 1 und die Lösung der auf die Vorrichtung gerichteten Aufgabe durch eine Vorrichtung gemäß Patentanspruch 7. Überwachungssysteme sind Gegenstand der Ansprüche 8 und 9. Vorteilhafte Ausgestaltungen sind jeweils Gegenstand der Unteransprüche.

Bei dem erfindungsgemäßen Verfahren zur Überwachung eines Lagerungszustandes einer Brennstoffzelle oder eines Stapels elektrisch in Serie geschalteter Brennstoffzellen, die einen Elektrolyten aufweist bzw. aufweisen und deren Gasräume während der Lagerung mit Wasserstoff beaufschlagt sind, werden Impedanzen der Brennstoffzelle oder des Brennstoffzellenstapels bei zumindest einer ersten und einer zweiten Frequenz ermittelt, wobei die erste Frequenz größer als die zweite Frequenz ist, und aus der ermittelten Impedanz bei der ersten Frequenz wird ein Feuchtegehalt des Elektrolyten überwacht und mit den bei beiden Frequenzen ermittelten Impedanzen wird eine Wasserstoffkonzentration in den Gasräumen überwacht.

Wie sich herausgestellt hat, bildet sich sowohl der Grad der Austrocknung des Elektrolyten als auch die Konzentration von Wasserstoff in den Gasräumen in der Impedanz der Brennstoffzelle ab. Der Feuchtegehalt des Elektrolyten bildet sich dabei über niedrige als auch hohe Frequenzbereiche ab (typischerweise unterhalb und oberhalb 500 Hz) ab, während sich die Wasserstoffkonzentration in den Gasräumen nur in niedrigeren Frequenzbereichen (typischerweise unter 500 Hz) abbildet. Durch geeignete Wahl der ersten und der zweiten Frequenz kann dann sichergestellt werden, dass sich bei der ersten (größeren) Frequenz nur der Einfluss des Feuchtegehaltes des Elektrolyten, aber nicht der Einfluss der Wasserstoffkonzentration in der Impedanz abbildet. Erfindungsgemäß wird die hierbei ermittelte elektrolyt-bedingte Impedanzerhöhung dann bei der bei der zweiten (kleineren) Frequenz ermittelten Impedanz in Abzug gebracht und es kann somit eine um eine elektrolyt-bedingte Impedanzerhöhung bereinigte Impedanz ermittelt werden, die nun nur noch durch die Wasserstoffkonzentration in den Gasräumen geprägt ist.

Eine Impedanzmessung kann somit überraschenderweise nicht nur zur Überwachung des Betriebszustandes von mit den Reaktanden betriebenen Brennstoffzellen (d.h. zu deren Überwachung im laufenden Betrieb), sondern auch zu Überwachung eines Lagerungszustandes außer Betrieb befindlicher Brennstoffzellen genutzt werden.

Durch die Erfindung ist somit eine Überwachung der wichtigsten Parameter von lagernden bzw. nicht-betriebenen Brennstoffzellen mit nur einem einzigen Messgerät und ohne Eingriffe in die Brennstoffzellen möglich. Es ist lediglich ein Zugang zu den Lastanschlüssen notwendig.

Die genauen Frequenzen lassen sich experimentell ermitteln. Wie sich für viele Brennstoffzellen, vor allem für PEM-Brennstoffzellen herausgestellt hat, sind gute Überwachungsergebnisse erzielbar, wenn die erste Frequenz in einem Frequenzbereich von 0,9 bis 1,1 kHz liegt, vorzugsweise 1 kHz beträgt, und die zweite Frequenz in einem Frequenzbereich von 0,9 bis 1,1 Hz liegt, vorzugsweise 1 Hz beträgt.

Gemäß einer besonders vorteilhaften Ausgestaltung werden die Impedanzen mit einem Strom gemessen, der eine Amplitude aufweist, die zwischen der Austauschstromdichte einer Anodenreaktion und der Austauschstromdichte einer Kathodenreaktion der Brennstoffzelle, jeweils multipliziert mit der aktiven Oberfläche der Brennstoffzelle bzw. der Brennstoffzellen des Brennstoffzellenstapels, liegt. Hierbei liegt die Erkenntnis zugrunde, dass es bei einer Stromamplitude in diesem Bereich und gleichzeitig fehlendem Wasserstoff in den anoden- und kathodenseitigen Gasräumen der Brennstoffzelle (bzw. Vorhandensein von Sauerstoff in den anoden- und kathodenseitigen Gasräumen der Brennstoffzelle) zu Durchtrittsüberspannungseffekten kommt, die im niederfrequenten Bereich zu einer Impedanzerhöhung der Brennstoffzelle führen. Anhand dieser Impedanzerhöhung kann dann auf eine zu geringe Wasserstoffkonzentration der Brennstoffzelle geschlossen werden.

Besonders bewährt hat sich bei PEM-Brennstoffzellen, wenn die Stromdichte zwischen 0,2 mA/cm² und 20 mA/cm², vorzugsweise 2 mA/cm², beträgt. Hintergrund ist hierbei, dass an der Anode und an der Kathode einer PEM-Brennstoffzelle jeweils eine Oxidations -und eine Reduktionsreaktion stattfindet. Im Gleichgewichtszustand, d.h. wenn kein äußerer Strom fließt bzw. bei leer laufender Brennstoffzelle, sind die durch die Oxidations- und Reduktionsreaktion resultierenden Ströme im Gleichgewicht. Der Betrag der Ströme bildet den jeweiligen Austauschstrom. Fließt dagegen ein äußerer Strom bei Brennstoffzellenbetrieb, so wird die Oxidationsreaktion an der Anode und die Reduktionsreaktion an der Kathode verstärkt und es entstehen u.a. Aktivierungsüberspannungen oberhalb der Austauschstromdichten. Die Oxidation und die Reduktion an der Anode und Kathode werden auch durch die Butler-Volmer-Gleichung beschrieben. Die Austauschstromdichte kann dabei rechnerisch mit Hilfe der sogenannten Tafel-Gleichung oder auch experimentell ermittelt werden.

Da die sich bei der Lagerung von Brennstoffzellen einstellenden Prozesse lang andauernde Prozess sind, ist es nicht notwendig, die Brennstoffzelle(n) kontinuierlich zu überwachen. Vielmehr erfolgt die Ermittlung der Impedanzen von Vorteil diskontinuierlich, vorzugsweise nur in periodischen zeitlichen Abständen wie einmal pro Tag, Woche oder Monat. Hierdurch kann eine für die Überwachung benötigte elektrische Energie eingespart werden, was beispielsweise eine Überwachung durch eine von einem elektrischen Versorgungsnetz getrennte, autarke Überwachungsvorrichtung möglich macht.
Die ermittelten Impedanzen können mit vorgegebenen Schwellwerten verglichen werden und ein Fehlersignal erzeugt werden, wenn einer der Schwellwerte überschritten oder unterschritten wird. Um die Funktionsfähigkeit der Überwachung zu signalisieren, kann nach mehreren Vergleichen der Impedanzen mit Schwellwerten, die zu keiner Erzeugung eines Fehlersignals führen, ein Lebenssignal erzeugt werden.

Gemäß einer weiteren vorteilhaften Ausgestaltung werden außerhalb der Zeiten, in der die Impedanzen der Brennstoffzelle oder des Brennstoffzellenstapels ermittelt werden, die elektrischen Lastanschlüsse der Brennstoffzelle kurzgeschlossen und somit ein Potenzialaufbau in der (den) Brennstoffzelle(n) verhindert.

Die Ermittlung der Impedanzen und/oder deren Auswertung muss dabei nicht vor Ort bei der (den) Brennstoffzelle(n) erfolgen, sondern kann auch räumlich davon entfernt, z.B. Cloudbasiert, erfolgen.

Eine erfindungsgemäße Vorrichtung zur Überwachung eines Lagerungszustandes einer Brennstoffzelle oder eines Stapels elektrisch in Serie geschalteter Brennstoffzellen, die einen Elektrolyten aufweist bzw. aufweisen und deren Gasräume während der Lagerung mit Wasserstoff beaufschlagt sind, wobei der Lagerungszustand ein Zustand ist, bei dem die Brennstoffzelle bzw. die Brennstoffzellen nicht an Versorgungseinrichtungen für Reaktanden angeschlossen sind, umfasst
- eine Messstromerzeugungseinrichtung zur Erzeugung eines Messstromes bei zumindest einer ersten und einer zweiten Frequenz, wobei die erste Frequenz größer als die zweite Frequenz ist,
- eine Messeinrichtung zur Messung der Spannung der Brennstoffzelle oder des Brennstoffzellenstapels bei der ersten und der zweiten Frequenz,
- eine Impedanzermittlungs- und auswerteeinrichtung zur Ermittlung der Impedanzen der Brennstoffzelle oder des Brennstoffzellenstapels bei der ersten und der zweiten Frequenz in Abhängigkeit von dem Messstrom und der gemessenen Spannung und zum Vergleichen der Impedanzen mit vorgegebenen Schwellwerten, wobei die Impedanzermittlungs- und auswerteeinrichtung eingerichtet ist, aus der ermittelten Impedanz bei der ersten Frequenz einen Feuchtegehalt des Elektrolyten zu überwachen und mit den bei beiden Frequenzen ermittelten Impedanzen eine Wasserstoffkonzentration in den Gasräumen zu überwachen, wobei eine bei der ersten Frequenz ermittelte elektrolyt-bedingte Impedanzerhöhung bei der bei der zweiten Frequenz ermittelten Impedanz in Abzug gebracht wird.

Die für das erfindungsgemäße Verfahren genannten Vorteile gelten entsprechend für diese erfindungsgemäße Vorrichtung.

Ein erstes erfindungsgemäßes Überwachungssystem unterscheidet sich von der erfindungsgemäßen Vorrichtung dadurch, dass es anstatt der Impedanzermittlungs- und auswerteeinrichtung nur eine Impedanzermittlungseinrichtung und dafür aber zusätzlich eine Übertragungseinrichtung zum Übertragen der ermittelten Impedanzwerte an eine davon räumlich entfernte, vorzugsweise Cloud-basierende, Impedanzauswerteeinrichtung aufweist.

Ein zweites erfindungsgemäßes Überwachungssystem unterscheidet sich von der erfindungsgemäßen Vorrichtung dadurch, dass es anstatt der Impedanzermittlungs- und auswerteeinrichtung nur eine Übertragungseinrichtung zum Übertragen gemessener Spannungswerte an eine davon räumlich entfernte, vorzugsweise Cloud-basierende, Impedanzermittlungs- und auswerteeinrichtung aufweist.

Von Vorteil ist es dabei, wenn die erste Frequenz in einem Frequenzbereich von 0,9 bis 1,1 kHz liegt, vorzugsweise 1 kHz beträgt, und dass die zweite Frequenz in einem Frequenzbereich von 0,9 bis 1,1 Hz liegt, vorzugsweise 1 Hz beträgt.

Gemäß einer weiteren vorteilhaften Ausgestaltung der erfindungsgemäßen Vorrichtung bzw. der erfindungsgemäßen Überwachungssysteme weist der Messstrom eine Amplitude zwischen der Austauschstromdichte einer Anodenreaktion und der Austauschstromdichte einer Kathodenreaktion der Brennstoffzelle(n), jeweils multipliziert mit der aktiven Oberfläche der Brennstoffzelle(n), auf.

Gemäß einer weiteren vorteilhaften Ausgestaltung weist die erfindungsgemäße Vorrichtung bzw. weisen die erfindungsgemäßen Überwachungssysteme eine Steuereinrichtung auf, die diskontinuierlich, vorzugsweise in periodischen, zeitlichen Abständen die Erzeugung des Messstromes und die Spannungsmessung auslöst.

Gemäß einer weiteren vorteilhaften Ausgestaltung weist die erfindungsgemäße Vorrichtung bzw. weisen die erfindungsgemäßen Überwachungssysteme einen Kurzschließer zum Kurzschließen von Lastanschlüssen der Brennstoffzelle oder des Brennstoffzellenstapels während Lagerungszeiten, in denen keine Spannungsmessung erfolgt, auf.

Für eine besonders einfache Montage können Schnittstellen zur lösbaren mechanischen Befestigung, insbesondere zum lösbaren Anschrauben oder Aufstecken, einer erfindungsgemäßen Vorrichtung an einer Brennstoffzelle oder einem Brennstoffzellenstapel und zur elektrischen Kontaktierung der Messstromerzeugungseinrichtung und der Messeinrichtung mit elektrischen Lastanschlüssen der Brennstoffzelle oder des Brennstoffzellenstapels vorhanden sein.

Ein Brennstoffzellenmodul kann eine Brennstoffzelle oder einen Stapel elektrisch in Serie geschalteter Brennstoffzellen umfassen und Schnittstellen zur Aufnahme einer vorstehend erläuterten Vorrichtung aufweisen.

Bei dem ersten erfindungsgemäßen Überwachungssystem kann die Impedanzauswerteeinrichtung als eine zentrale Einrichtung für eine Vielzahl zu überwachender Brennstoffzellen oder Brennstoffzellenstapeln genutzt werden.

Bei dem zweiten erfindungsgemäßen Überwachungssystem kann die Impedanzermittlungs- und Impedanzauswerteeinrichtung als eine zentrale Einrichtung für eine Vielzahl zu überwachender Brennstoffzellen oder Brennstoffzellenstapeln genutzt werden.

Die Erfindung sowie weitere vorteilhafte Ausgestaltungen der Erfindung gemäß Merkmalen der Unteransprüche werden im Folgenden anhand von Ausführungsbeispielen in den Figuren näher erläutert. Dabei sind einander entsprechende Teile mit jeweils gleichen Bezugszeichen versehen. Es zeigen:
- FIG 1: ein aus dem Stand der Technik bekanntes Brennstoffzellenmodul mit einem Brennstoffzellenstapel in vereinfachter Darstellung,
- FIG 2: einen prinzipiellen Aufbau einer PEM-Brennstoffzelle,
- FIG 3: einen prinzipiellen Aufbau einer erfindungsgemäßen Vorrichtung zur Überwachung eines Lagerungszustandes einer Brennstoffzelle oder eines Brennstoffzellenstapels,
- FIG 4: ein Beispiel für eine Außenansicht einer Überwachungsvorrichtung gemäß FIG 3,
- FIG 5: eine beispielhafte Befestigung der Überwachungsvorrichtung nach FIG 3 an dem Brennstoffzellenmodul von FIG 1,
- FIG 6: einen Impedanzverlauf in Abhängigkeit von der Frequenz eines Messstromes für eine intakte PEM-Brennstoffzelle und eine Brennstoffzelle mit zu geringem Feuchtegehalt,
- FIG 7: einen Impedanzverlauf in Abhängigkeit von der Frequenz eines Messstromes für eine Brennstoffzelle mit zu wenig Wasserstoffüberschuss in den Gasräumen,
- FIG 8: einen Impedanzverlauf in Abhängigkeit von der Frequenz eines Messstromes für eine Brennstoffzelle sowohl mit zu geringem Feuchtegeahlt der Membran als auch mit zu wenig Wasserstoffüberschuss in den Gasräumen,
- FIG 9: eine experimentelle Ermittlung der Austauschstromdichte,
- FIG 10: ein Überwachungssystem mit einer cloud-basierenden Impedanzauswerteeinrichtung,
- FIG 11: das Überwachungssystem von FIG 10 mit einer Überwachung mehrerer Brennstoffzellenmodule,
- FIG 12: ein Überwachungssystem mit einer cloud-basierenden Impedanzermittlung- und -auswerteeinrichtung,
- FIG 13: das Überwachungssystem von FIG 12 mit einer Überwachung mehrerer Brennstoffzellenmodule.

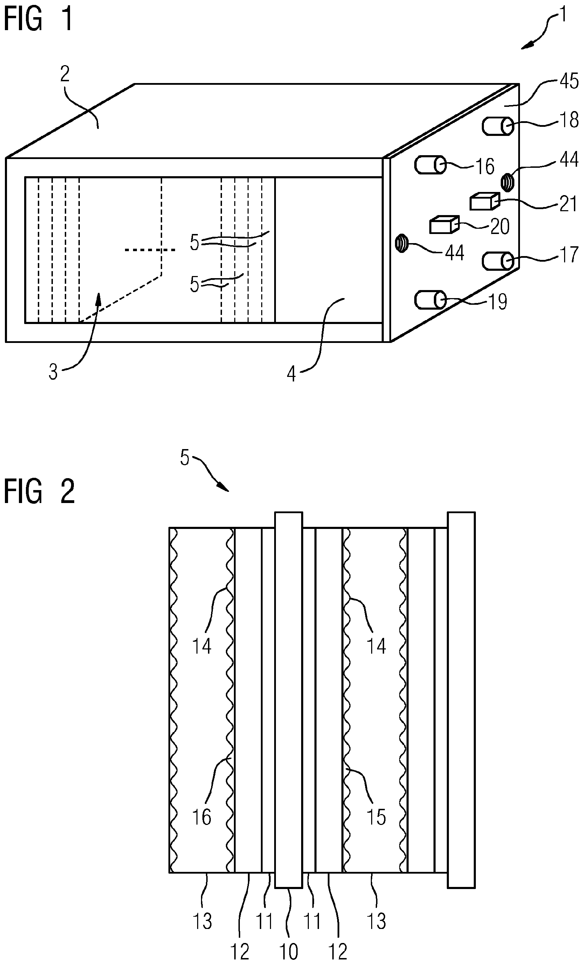

FIG 1 zeigt in vereinfachter Darstellung ein Brennstoffzellenmodul 1, das - von einem Gehäuse 2 umgeben - einen Brennstoffzellenstapel 3 und einen Betriebsteil 4 umfasst.

Der Brennstoffzellenstapel 3 besteht wiederum aus mehreren aufeinander gestapelten und hierdurch elektrisch in Reihe geschalteten einzelnen Brennstoffzellen 5, hier PEM-Brennstoffzellen.

Jede der Brennstoffzellen weist - wie vereinfacht in FIG 2 in einem Schnitt dargestellt ist - eine Membran 10 und beidseitig davon jeweils eine Katalysatorschicht 11 und eine Elektrode 12 oder Gasdiffusionsschicht auf. Daran schließt sich eine Bipolarplatte 13 an, die die elektrische Verbindung zur nächsten Brennstoffzelle 5 herstellt und in der Gasverteilerstrukturen 14 eingebracht sind, durch die Gasräume 15, 16 für die Reaktanden Wasserstoff und Sauerstoff ausgebildet sind. Die an einem Gasraum 15 für Wasserstoff anliegende Elektrode 12 wird auch Anode und die an einem Gasraum 16 für Sauerstoff anliegende Elektrode 12 wird auch Kathode genannt. Kanäle zur Zu- und Abfuhr der Reaktanden zu bzw. von den Brennstoffzellen, Dichtungen etc. sind zur Vereinfachung der Darstellung nicht dargestellt.

Das Betriebsteil 4 umfasst Anschlusstechnik, Sensoren, Ventile, Wasserabscheider, etc. des Brennstoffzellenmoduls 1.

Am betriebsteilseitigen Ende des Brennstoffzellenmoduls 1 finden sich deshalb Anschlüsse 16, 17 für die Wasserstoffzufuhr bzw. -abfuhr und Anschlüsse 18, 19 für die Sauerstoffzufuhr bzw. -abfuhr (siehe FIG 1).

Weiterhin sind am betriebsteilseitigen Ende des Brennstoffzellenmoduls 1 elektrische Lastanschlüsse 20, 21 nach außen geführt, an die eine mit Strom des Brennstoffzellenmoduls 1 zu speisende Last (nicht dargestellt) anschließbar ist.

Bei dem Brennstoffzellenmodul 1 handelt es sich um ein in einem Lager für Brennstoffzellenmodule eingelagertes, nichtbetriebenes Modul. Die Anschlüsse 16, 17, 18, 19 sind deshalb von entsprechenden Versorgungs- und -entsorgungssystemen für Wasserstoff und Sauerstoff getrennt. Beispielsweise sind die Anschlüsse mit aufgeschraubten Deckeln gasdicht verschlossen. Außerdem sind die Lastanschlüsse 20, 21 nicht mit einer Last verbunden. Die Gasräume 15, 16 sind zur Vermeidung von Korrosion und Oxidierungen mit Wasserstoff beaufschlagt.

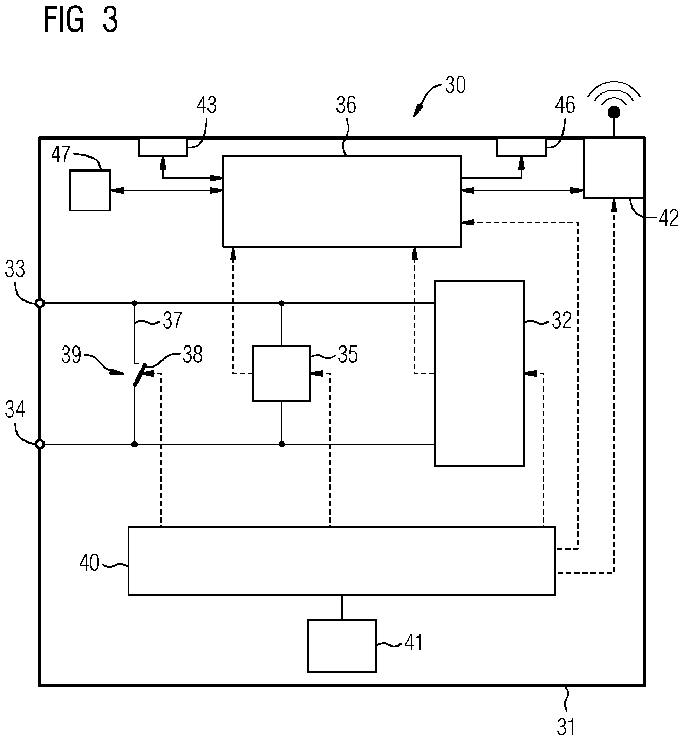

FIG 3 zeigt in prinzipieller Darstellung eine erfindungsgemäße Vorrichtung 30 zur Überwachung des Lagerungszustandes des Brennstoffzellenmoduls 1. Die Vorrichtung umfasst - umgeben von einem Gehäuse 31 - eine Messstromerzeugungseinrichtung 32 zur Erzeugung eines Messstromes für den Brennstoffzellenstapel 3, eine Messeinrichtung 35 zur Messung der Spannung an den Lastanschlüssen 20, 21 des Brennstoffzellenstapels 3 und eine Impedanzermittlungs- und auswerteeinrichtung 36.

Die Messstromerzeugungseinrichtung 32 dient zur Erzeugung eines Messstromes bei zumindest einer ersten und einer zweiten Frequenz, wobei die erste Frequenz größer als die zweite Frequenz ist.

Die Messeinrichtung 35 dient zur Messung der Spannung der Brennstoffzelle oder des Brennstoffzellenstapels bei der ersten und der zweiten Frequenz.

Die Impedanzermittlungs- und auswerteeinrichtung 36 dient zur Ermittlung der Impedanzen der Brennstoffzelle oder des Brennstoffzellenstapels bei der ersten und der zweiten Frequenz in Abhängigkeit von dem Messstrom und der gemessenen Spannung und zum Vergleichen der Impedanzen mit vorgegebenen Schwellwerten, um aus der ermittelten Impedanz bei der ersten Frequenz einen Feuchtegehalt des Elektrolyten zu überwachen und somit eine Austrocknung des Elektrolyten zu vermeiden, und mit den bei beiden Frequenzen ermittelten Impedanzen eine Wasserstoffkonzentration in den Gasräumen zu überwachen und somit eine Wasserstoffunterversorgung zu verhindern.

Die Messstromerzeugungseinrichtung 32 und die Messeinrichtung 35 sind hierzu über Kontakte 33, 34 mit den elektrischen Lastanschlüssen 20, 21 des Brennstoffzellenstapels 3 elektrisch verbindbar.

Über eine elektrische Verbindung 37 mit einem Schalter 38 ist ein Kurzschließer 39 realisiert und somit ein elektrischer Kurzschluss an den Kontakten 33, 34 und somit an den Lastanschlüssen 20, 21 anlegbar.

Eine Steuereinrichtung 40 steuert die einzelnen Komponenten 32, 25, 36, 38, insbesondere versorgt sie diese mit elektrischer Energie aus einem Energiespeicher 41 (z.B. einer Batterie). Durch den Energiespeicher 41 ist dabei für eine bestimmte Zeit, z.B. ein Jahr, eine netzunabhängige, autarke Stromversorgung für die Vorrichtung 30 möglich. Die Steuereinrichtung 40 löst diskontinuierlich, vorzugsweise in periodischen, zeitlichen Abständen die Erzeugung des Messstromes durch die Messstromerzeugungseinrichtung 32 und die Spannungsmessung durch die Messeinrichtung 35 aus.

Die Steuereinrichtung 40 steuert den Kurzschließer 39 dabei derart an, dass die Lastanschlüsse 20, 21 kurzgeschlossen sind, wenn keine Spannungsmessung erfolgt. Von Vorteil erfolgt zur Energieeinsparung die Ansteuerung derart, dass die Lastanschlüsse 20, 21 ohne Spannungserregung durch die Steuereinrichtung 40 kurzgeschlossen und mit Spannungserregung durch die Steuereinrichtung 40 nicht kurzgeschlossen sind.

Weiterhin umfasst die Überwachungsvorrichtung 30 optional eine mit der Impedanzberechnungs- und auswerteeinrichtung 36 gekoppelte Übertragungseinrichtung 42 zur drahtlosen Kommunikation mit einer übergeordneten Überwachungseinrichtung sowie eine Schnittstelle 43 für eine drahtgebundene Kommunikation mit einer übergeordneten Überwachungseinrichtung.

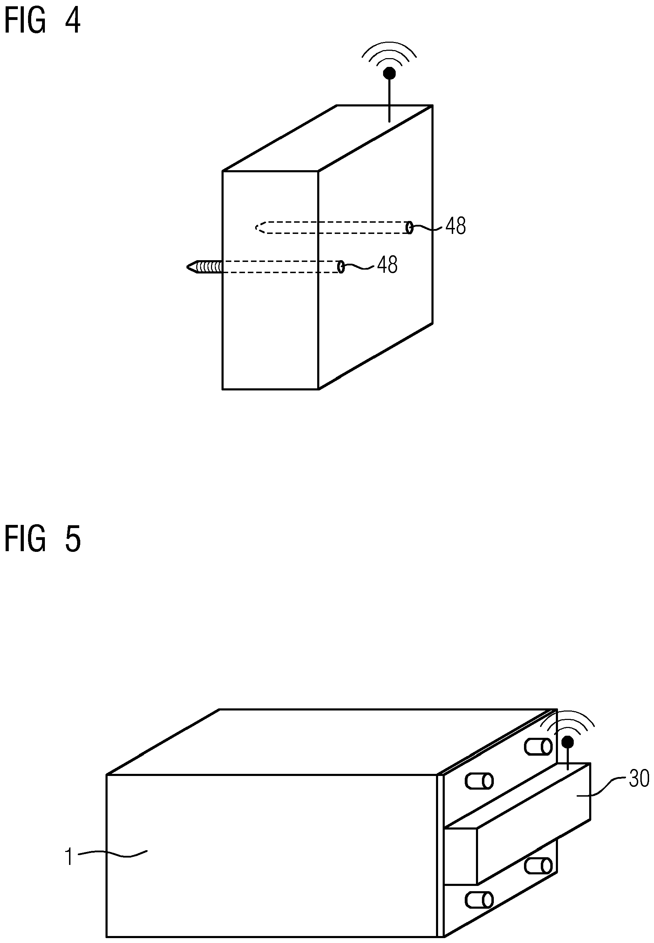

Das Gehäuse 31 der Überwachungsvorrichtung 30 weist weiterhin Schnittstellen zur lösbaren mechanischen Befestigung, insbesondere zum lösbaren Anschrauben oder Aufstecken, der Vorrichtung 30 an das betriebsteilseitige Ende des Brennstoffzellenmoduls 1 und zur elektrischen Kontaktierung der Anschlusskontakte 33, 34 mit den elektrischen Lastanschlüssen 20, 21 des Brennstoffzellenmoduls 1 auf. Umgekehrt weist auch das Brennstoffzellenmodul 1 eine Schnittstelle zur Aufnahme der Überwachungsvorrichtung 30 auf. Für die Schnittstellen gibt es unzählige Ausführungsmöglichkeiten, z.B. in Form von Steckverbindungen oder Schraubverbindungen. Beispielhaft ist gemäß FIG 4 das Gehäuse 31 über mehrere Schrauben 48 in Gewindebohrungen 44 einschraubbar, die in eine Abschlussplatte 45 des Moduls 1 eingearbeitet sind (siehe FIG 1). FIG 5 zeigt beispielshaft die auf das Brennstoffzellenmodul 1 montierte Überwachungsvorrichtung 30.

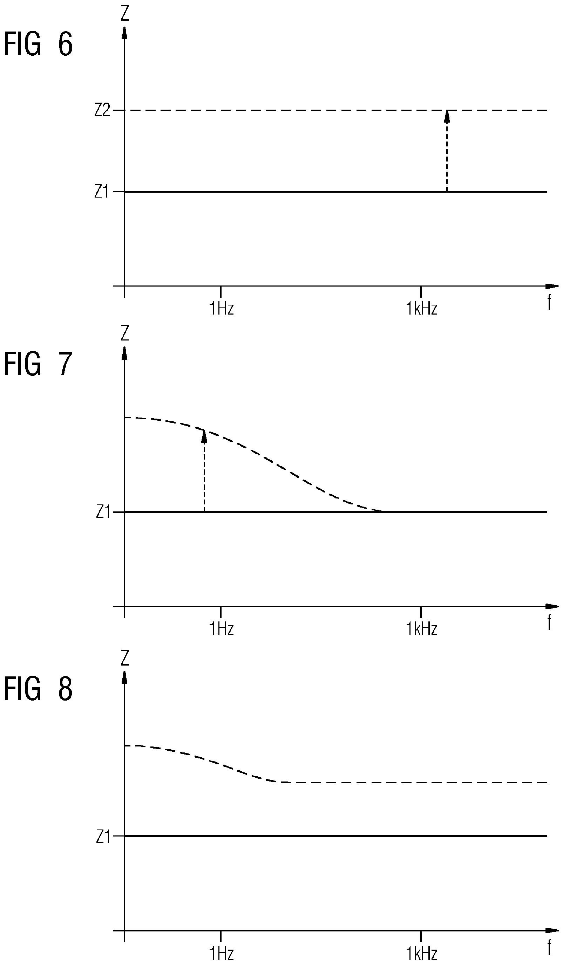

Anhand von FIG 6 bis 10 wird nun im Detail das durch die Vorrichtung 30 realisierte Überwachungsverfahren erläutert.

FIG 6 zeigt hierzu beispielhaft über der Frequenz f die Impedanz Z einer PEM-Brennstoffzelle. Mit durchgezogener Linie ist dabei in logarithmischer Darstellung der Impedanzverlauf für Frequenzen f bis 10 KHz für eine intakte Brennstoffzelle (d.h. mit ausreichendem Feuchtegehalt der Elektrolyt-Membran und ausreichender Wasserstoffkonzentration in den Gasräumen) und im Vergleich dazu mit gestrichelter Linie der Impedanzverlauf bei mangelndem Feuchtegehalt der Elektrolyt-Membran (aber ausreichender Wasserstoffkonzentration in den Gasräumen) dargestellt. Wie ersichtlich ist, führt der mangelnde Feuchtegehalt zu einer (nahezu konstanten) Vergrößerung der Impedanz über den gesamten Frequenzbereich von einem Wert Z1 auf einen Wert Z2.

FIG 7 zeigt im Vergleich dazu mit gestrichelter Linie den Impedanzverlauf bei mangelnder Wasserstoffkonzentration in den Gasräumen (aber ausreichendem Feuchtegehalt der Membran). Wie ersichtlich ist, führt die mangelnde Wasserstoffkonzentration zu einer Vergrößerung der Impedanz nur im unteren Frequenzbereich.

FIG 8 zeigt nun im Vergleich dazu mit gestrichelter Linie den Impedanzverlauf bei sowohl mangelnder Wasserstoffkonzentration in den Gasräumen als auch mangelndem Feuchtegehalt der Membran. Wie ersichtlich ist, führt dies zu einer Vergrößerung der Impedanz im gesamten Frequenzbereich.

Zusammengefast kann somit durch Ermittlung der Impedanz im oberen Frequenzbereich auf den Feuchtegehalt und somit ein Austrocknen der Membran geschlossen werden und durch eine Ermittlung der Impedanz im unteren Frequenzbereich auf die Wasserstoffkonzentration in den Gasräumen geschlossen werden, wobei aber im letzteren Fall die bei der ersten Frequenz ermittelte Impedanz zur Korrektur der bei der zweiten Frequenz ermittelten Impedanz verwendet werden muss, um Fehlschlüsse zu vermeiden.

Gute Messergebnisse stellen sich dabei ein, wenn die erste Frequenz in einem Frequenzbereich von 0,9 bis 1,1 kHz liegt, vorzugsweise 1 kHz beträgt, und die zweite Frequenz in einem Frequenzbereich von 0,9 bis 1,1 Hz liegt, vorzugsweise 1 Hz beträgt.

Die Impedanzen werden dabei mit einem Strom gemessen, der eine Amplitude aufweist, die zwischen der Austauschstromdichte einer Anodenreaktion und der Austauschstromdichte einer Kathodenreaktion der Brennstoffzelle, jeweils multipliziert mit der aktiven Oberfläche der Brennstoffzelle bzw. der Brennstoffzellen des Brennstoffzellenstapels, liegt.

Besonders bewährt hat sich bei PEM-Brennstoffzellen, wenn die Stromdichte zwischen 0,2 mA/cm² und 20 mA/cm², vorzugsweise 2 mA/cm², beträgt.

Die Austauschstromdichte kann dabei rechnerisch mit Hilfe der sogenannten Tafel-Gleichung oder auch experimentell ermittelt werden.

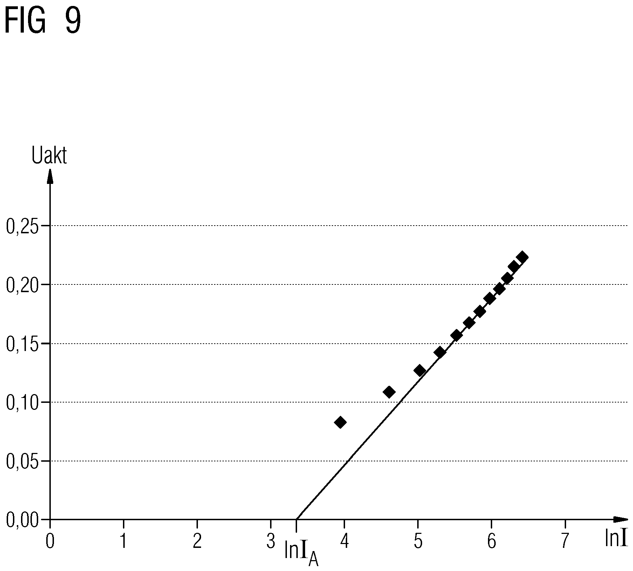

FIG 9 zeigt hierzu ein Beispiel für eine experimentelle Ermittlung. Hierzu werden an einer Brennstoffzelle die Stromdichte I und die Aktivierungsgegenspannung Uakt gemessen und der natürliche Logarithmus der Stromdichte ln(I) auf der Abszisse über der Aktivierungsgegenspannung Uakt an der Ordinate aufgetragen. Durch Verlängerung des linearen Bereichs der Kurve erhält man einen Schnittpunkt lnI_{A} mit der Abszisse. Der Wert des Schnittpunkts entspricht dann näherungsweise der Austauschstromdichte.

Wiederum bezugnehmend auf FIG 3 steuert die Steuereinrichtung 40 nun die Vorrichtung 30 derart, dass die Ermittlung der Impedanzen diskontinuierlich, vorzugsweise nur in periodischen zeitlichen Abständen wie einmal pro Tag, Woche oder Monat, erfolgt.

Außerhalb der Zeiten, in der die Impedanz der Brennstoffzellen ermittelt wird, sind die elektrischen Lastanschlüsse 20, 21 des Moduls 1 kurzgeschlossen und es wird somit ein unerwünschter Potenzialaufbau vermieden.

Die ermittelten Impedanzen werden in der Impedanzberechnungs- und auswerteeinrichtung 36 mit vorgegebenen Schwellwerten verglichen und ein Fehlersignal erzeugt und mittels einer optischen oder akustischen Anzeige 46 nach außen signalisiert, wenn ein in einem Speicher 47 gespeicherter Schwellwert überschritten wird. Vorzugsweise wird durch die Impedanzberechnungs- und auswerteeinrichtung 36 nach mehreren Vergleichen der Impedanzen mit Schwellwerten, die zu keiner Erzeugung eines Fehlersignals führten, ein Lebenssignal erzeugt und ebenfalls mittels der optischen oder akustischen Anzeige 46 nach außen signalisiert. Lagerpersonal erhält somit eine Information, dass die Überwachung funktioniert und kein Fehler bzw. ein Fehler vorliegt.

Die ermittelten Impedanzen und/oder die Fehler- und Lebenssignale können von der Impedanzberechnungs- und auswerteeinrichtung 36 zusammen mit Zeitstempeln auch in dem für Lagerpersonal auslesbaren Speicher 47 abgespeichert und/oder über die Übertragungseinrichtungen 42, 43 an zentrale, insbesondere Cloud-basierende, Überwachungssysteme übertragen werden, die beispielsweise vom Hersteller der Brennstoffzellen betrieben werden. Es können somit eine Vielzahl von Brennstoffzellenmodulen 1 überwacht und beispielsweise Serienfehler leichter identifiziert werden.

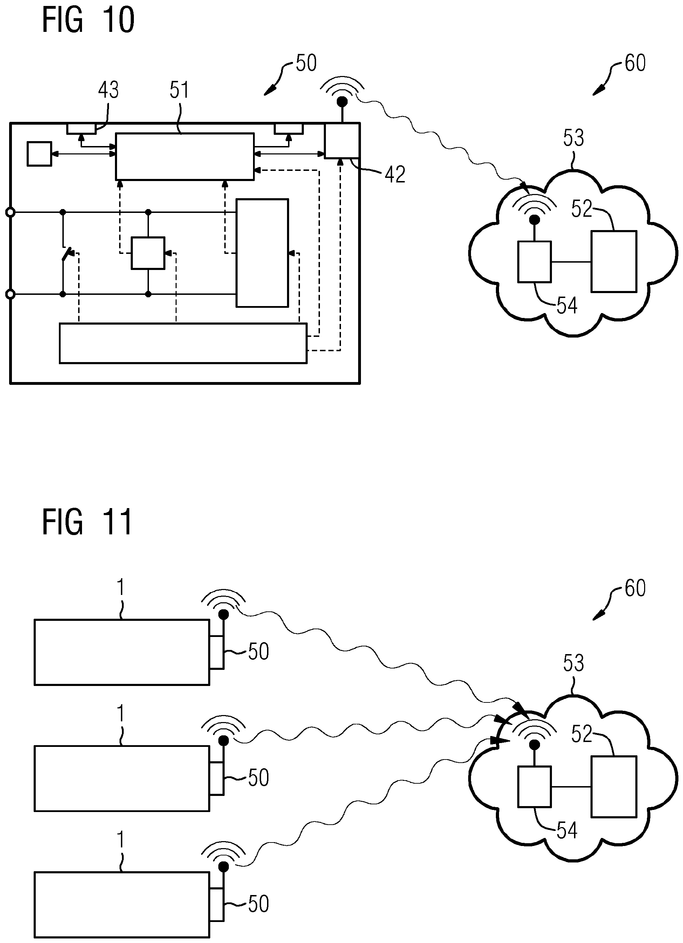

Eine in FIG 10 gezeigte Überwachungsvorrichtung 50 unterscheidet sich von der in FIG 3 gezeigten Überwachungsvorrichtung 30 dadurch, dass sie anstatt der Impedanzermittlungs- und auswerteeinrichtung 36 nur eine Impedanzermittlungseinrichtung 51 aufweist und die Übertragungseinrichtungen 42, 43 zum Übertragen der ermittelten Impedanzwerte an eine davon räumlich entfernte Impedanzauswerteeinrichtung 52 ausgebildet sind. Die Impedanzauswerteeinrichtung 52 basiert auf einer Cloud 53 und ihr ist noch eine Empfangseinrichtung 54 für die von der Überwachungsvorrichtung 50 übertragenen Impedanzwerte zugeordnet. Die Überwachungsvorrichtung 50, die Impedanzermittlungseinrichtung 51 und die Empfangseinrichtung 54 bilden somit ein Überwachungssystem 60.

Gemäß FIG 11 kann das System 60 auch zur Überwachung mehrerer Brennstoffzellenmodule 1 mit jeweils einer daran montierten Überwachungsvorrichtung 50 genutzt werden.

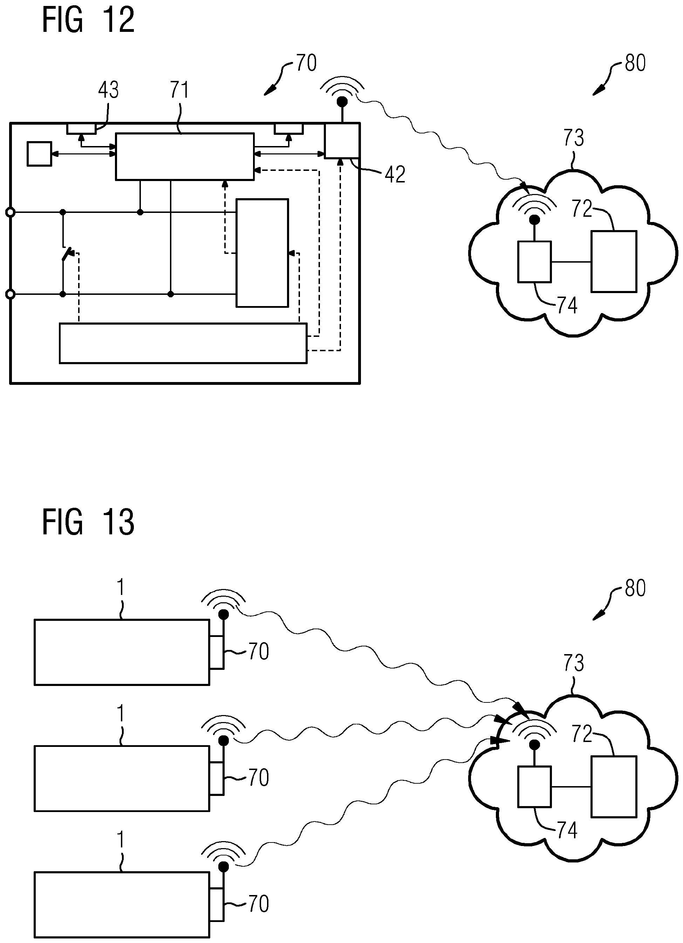

Eine in FIG 12 gezeigte Überwachungsvorrichtung 70 unterscheidet sich von der in FIG 3 gezeigten Überwachungsvorrichtung 30 dadurch, dass sie keine Impedanzermittlungs- und auswerteeinrichtung 36 aufweist. Anstatt dessen ist die Messeinrichtung 71 direkt mit den Übertragungseinrichtungen 42, 43 zum Übertragen gemessener Spannungswerte an eine räumlich entfernte Impedanzermittlungs- und auswerteeinrichtung 72 ausgebildet. Die Impedanzermittlungs- und auswerteeinrichtung 72 basiert auf einer Cloud 73 und ihr ist noch eine Empfangseinrichtung 74 für die von der Überwachungsvorrichtung 70 übertragenen Spannungswerte zugeordnet. Die Überwachungsvorrichtung 70, die Impedanzermittlungs- und auswerteeinrichtung 72 und die Empfangseinrichtung 74 bilden somit ein Überwachungssystem 80.

Gemäß FIG 13 kann das System 80 auch zur Überwachung mehrerer Brennstoffzellenmodule 1 mit jeweils einer daran montierten Überwachungsvorrichtung 70 genutzt werden.

Beispielhaft ist in FIG 10 - 13 die Übertragung der Impedanzwerte bzw. Spannungswerte zwischen der Überwachungsvorrichtung 50 bzw. 70 und der Cloud 53 bzw. 73 drahtlos mittels der Übertragungseinrichtung 42 gezeigt (z.B. auf Basis UMTS), sie kann aber auch drahtgebunden mittels der Übertragungseinrichtung 43 sein (z.B. auf Basis Ethernet) oder eine Kombination davon (z.B. eine Kombination von WLAN und Ethernet). Falls zwischen der Überwachungsvorrichtung 50 bzw. 70 und der Impedanzauswerteeinrichtung 52 bzw. 72 eine bidirektionale Kommunikation möglich ist, kann das Ergebnis der Impedanzauswertung, z.B. ein Fehlersignal, oder auch ein Lebenssignal, von der Impedanzauswerteeinrichtung 52 bzw. 72 an die Überwachungsvorrichtung 50 bzw. 70 übertragen und an dieser beispielsweise optisch ausgegeben werden.

Durch die Erfindung ist somit eine Überwachung der wichtigsten Parameter von lagernden bzw. nicht-betriebenen Brennstoffzellen 5 mit nur einem einzigen Messprinzip und ohne Eingriffe in die Brennstoffzellen möglich. Es ist lediglich ein Zugang zu den Lastanschlüssen 20, 21 notwendig.

## Patentansprüche

1. Verfahren zur Überwachung eines Lagerungszustandes einer Brennstoffzelle (5) oder eines Stapels (3) elektrisch in Serie geschalteter Brennstoffzellen (5), die einen Elektrolyten (10) aufweist bzw. aufweisen und deren Gasräume (15, 16) während der Lagerung mit Wasserstoff beaufschlagt sind, wobei der Lagerungszustand ein Zustand ist, bei dem die Brennstoffzelle (5) bzw. die Brennstoffzellen (5) nicht an Versorgungseinrichtungen für Reaktanden angeschlossen sind,
**dadurch gekennzeichnet, dass**
Impedanzen der Brennstoffzelle (5) oder des Brennstoffzellenstapels (3) bei zumindest einer ersten und einer zweiten Frequenz (f1 bzw. f2) ermittelt werden, wobei die erste Frequenz (f1) größer als die zweite Frequenz (f2) ist, und wobei aus der ermittelten Impedanz bei der ersten Frequenz (f1) ein Feuchtegehalt des Elektrolyten (10) überwacht und mit den bei beiden Frequenzen (f1, f2) ermittelten Impedanzen eine Wasserstoffkonzentration in den Gasräumen (15, 16) überwacht wird, wobei eine bei der ersten Frequenz (f1) ermittelte elektrolyt-bedingte Impedanzerhöhung bei der bei der zweiten Frequenz (f2) ermittelten Impedanz in Abzug gebracht wird.

2. Verfahren nach Anspruch 1,
**dadurch gekennzeichnet, dass** die erste Frequenz (f1) in einem Frequenzbereich von 0,9 bis 1,1 kHz liegt, vorzugsweise 1 kHz beträgt, und dass die zweite Frequenz (f2) in einem Frequenzbereich von 0,9 bis 1,1 Hz liegt, vorzugsweise 1 Hz beträgt.

3. Verfahren nach einem der vorhergehenden Ansprüche,
**dadurch gekennzeichnet, dass** die Impedanzen mit einem Strom gemessen werden, der eine Amplitude aufweist, die zwischen der Austauschstromdichte einer Anodenreaktion und der Austauschstromdichte einer Kathodenreaktion der Brennstoffzelle(n) (5), jeweils multipliziert mit der aktiven Oberfläche der Brennstoffzelle(n)(5), liegt.

4. Verfahren nach einem der vorhergehenden Ansprüche,
**dadurch gekennzeichnet, dass** die Ermittlung der Impedanzen diskontinuierlich, vorzugsweise in periodischen zeitlichen Abständen wie einmal pro Tag, Woche oder Monat, erfolgt.

5. Verfahren nach einem der vorhergehenden Ansprüche, **dadurch gekennzeichnet, dass** die ermittelten Impedanzen mit vorgegebenen Schwellwerten verglichen werden und ein Fehlersignal erzeugt wird, wenn einer der Schwellwerte überschritten oder unterschritten wird, vorzugsweise nach mehreren Vergleichen der Impedanzen mit Schwellwerten, die zu keiner Erzeugung eines Fehlersignals führen, ein Lebenssignal erzeugt wird.

6. Verfahren nach einem der vorhergehenden Ansprüche, **dadurch gekennzeichnet, dass** außerhalb von Zeiten, in der die Impedanzen der Brennstoffzelle(n) (5) ermittelt werden, die elektrischen Lastanschlüsse (20, 21) der Brennstoffzelle (5) oder des Brennstoffzellenstapels (3) kurzgeschlossen werden.

7. Vorrichtung (30) zur Überwachung eines Lagerungszustandes einer Brennstoffzelle (5) oder eines Stapels (3) elektrisch in Serie geschalteter Brennstoffzellen (5), die einen Elektrolyten (10) aufweist bzw. aufweisen und deren Gasräume (15, 16) während der Lagerung mit Wasserstoff beaufschlagt sind, wobei der Lagerungszustand ein Zustand ist, bei dem die Brennstoffzelle (5) bzw. die Brennstoffzellen (5) nicht an Versorgungseinrichtungen für Reaktanden angeschlossen sind, **gekennzeichnet durch**
- eine Messstromerzeugungseinrichtung (32) zur Erzeugung eines Messstromes bei zumindest einer ersten und einer zweiten Frequenz (f1 bzw. f2), wobei die erste Frequenz (f1) größer als die zweite Frequenz (f2) ist,
- eine Messeinrichtung (35) zur Messung der Spannung der Brennstoffzelle (5) oder des Brennstoffzellenstapels (3) bei der ersten und der zweiten Frequenz (f1 bzw. f2),
- eine Impedanzermittlungs- und auswerteeinrichtung (36) zur Ermittlung der Impedanzen der Brennstoffzelle (5) oder des Brennstoffzellenstapels (3) bei der ersten und der zweiten Frequenz (f1, f2) in Abhängigkeit von dem Messstrom und der gemessenen Spannung und zum Vergleichen der Impedanzen mit vorgegebenen Schwellwerten, wobei die Impedanzermittlungs- und auswerteeinrichtung (36) eingerichtet ist, aus der ermittelten Impedanz bei der ersten Frequenz (f1) einen Feuchtegehalt des Elektrolyten zu überwachen und mit den bei beiden Frequenzen (f1, f2) ermittelten Impedanzen eine Wasserstoffkonzentration in den Gasräumen (15, 16) zu überwachen, wobei eine bei der ersten Frequenz (f1) ermittelte elektrolyt-bedingte Impedanzerhöhung bei der bei der zweiten Frequenz (f2) ermittelten Impedanz in Abzug gebracht wird.

8. Überwachungssystem (60) zur Überwachung eines Lagerungszustandes einer Brennstoffzelle (5) oder eines Stapels (3) elektrisch in Serie geschalteter Brennstoffzellen (5), die einen Elektrolyten (10) aufweist bzw. aufweisen und deren Gasräume (15, 16) während der Lagerung mit Wasserstoff beaufschlagt sind, wobei der Lagerungszustand ein Zustand ist, bei dem die Brennstoffzelle (5) bzw. die Brennstoffzellen (5) nicht an Versorgungseinrichtungen für Reaktanden angeschlossen sind, wobei das Überwachungssystem eine Überwachungs-Vorrichtung (50) umfassend
- eine Messstromerzeugungseinrichtung (32) zur Erzeugung eines Messstromes bei zumindest einer ersten und einer zweiten Frequenz (f1 bzw. f2), wobei die erste Frequenz (f1) größer als die zweite Frequenz (f2) ist,
- eine Messeinrichtung (35) zur Messung der Spannung der Brennstoffzelle (5) oder des Brennstoffzellenstapels (3) bei der ersten und der zweiten Frequenz (f1 bzw. f2),
- eine Impedanzermittlungseinrichtung (51) zur Ermittlung der Impedanz der Brennstoffzelle (5) oder des Brennstoffzellenstapels (3) bei der ersten und der zweiten Frequenz (f1 bzw. f2) in Abhängigkeit von dem Messstrom und der gemessenen Spannung, und
- eine Übertragungseinrichtung (42, 43) zum Übertragen ermittelter Impedanzwerte an eine davon räumlich entfernte, vorzugsweise Cloud-basierende, Impedanzauswerteeinrichtung (52)
und räumlich von der Überwachungs-Vorrichtung (50) entfernt, vorzugsweise Cloud-basierend,
- eine Empfangseinrichtung (54) zum Empfang der ermittelten Impedanzwerte und
- eine Impedanzauswerteeinrichtung (52)
aufweist,
wobei die Impedanzauswerteeinrichtung (52) eingerichtet ist zum Vergleichen der empfangenen Impedanzwerte mit vorgegebenen Schwellwerten und eingerichtet ist, mit der ermittelten Impedanz bei der ersten Frequenz (f1) einen Feuchtegehalt des Elektrolyten (10) zu überwachen und mit den bei beiden Frequenzen (f1, f2) ermittelten Impedanzen eine Wasserstoffkonzentration in den Gasräumen (15, 16) zu überwachen, wobei eine bei der ersten Frequenz (f1) ermittelte elektrolyt-bedingte Impedanzerhöhung bei der bei der zweiten Frequenz (f2) ermittelten Impedanz in Abzug gebracht wird.

9. Überwachungssystem (80) zur Überwachung eines Lagerungszustandes einer Brennstoffzelle (5) oder eines Stapels (3) elektrisch in Serie geschalteter Brennstoffzellen (5), die einen Elektrolyten (10) aufweist bzw. aufweisen und deren Gasräume (15, 16) während der Lagerung mit Wasserstoff beaufschlagt sind, wobei der Lagerungszustand ein Zustand ist, bei dem die Brennstoffzelle (5) bzw. die Brennstoffzellen (5) nicht an Versorgungseinrichtungen für Reaktanden angeschlossen sind, wobei das Überwachungssystem eine Überwachungs-Vorrichtung (70) umfassend
- eine Messstromerzeugungseinrichtung (32) zur Erzeugung eines Messstromes bei zumindest einer ersten und einer zweiten Frequenz (f1, f2), wobei die erste Frequenz (f1) größer als die zweite Frequenz (f2) ist,
- eine Messeinrichtung (71) zur Messung der Spannung der Brennstoffzelle (5) oder des Brennstoffzellenstapels (3) bei der ersten und der zweiten Frequenz (f1, f2),
- eine Übertragungseinrichtung (42, 43) zum Übertragen gemessener Spannungswerte an eine davon räumlich entfernte, vorzugsweise Cloud-basierende, Impedanzermittlungs- und auswerteeinrichtung (72)
und räumlich entfernt von der Überwachungs-Vorrichtung (70), vorzugsweise Cloud-basierend,
- eine Empfangseinrichtung (74) zum Empfang der gemessenen Spannungswerte und
- eine Impedanzermittlungs- und auswerteeinrichtung (72) umfasst,
wobei die Impedanzermittlungs- und auswerteeinrichtung (72) eingerichtet ist zur Ermittlung der Impedanzen der Brennstoffzelle (5) oder des Brennstoffzellenstapels (3) bei der ersten und der zweiten Frequenz (f1 bzw. f2) in Abhängigkeit von dem Messstrom und der gemessenen Spannung und zum Vergleichen der Impedanzen mit vorgegebenen Schwellwerten, und eingerichtet ist, mit der ermittelten Impedanz bei der ersten Frequenz (f1) einen Feuchtegehalt des Elektrolyten (10) zu überwachen und mit den bei beiden Frequenzen (f1, f2) ermittelten Impedanzen eine Wasserstoffkonzentration in den Gasräumen (15, 16) zu überwachen, wobei eine bei der ersten Frequenz (f1) ermittelte elektrolyt-bedingte Impedanzerhöhung bei der bei der zweiten Frequenz (f2) ermittelten Impedanz in Abzug gebracht wird.

10. Vorrichtung (30, 50, 70) nach Anspruch 7 oder Überwachungssystem (60, 80) nach einem der Ansprüche 8 oder 9, **dadurch gekennzeichnet, dass** die erste Frequenz in einem Frequenzbereich von 0,9 bis 1,1 kHz liegt, vorzugsweise 1 kHz beträgt, und dass die zweite Frequenz in einem Frequenzbereich von 0,9 bis 1,1 Hz liegt, vorzugsweise 1 Hz beträgt.

11. Vorrichtung (30, 50, 70) nach Anspruch 7 oder 10, oder Überwachungssystem (60, 80) nach einem der Ansprüche 8 bis 10,
**dadurch gekennzeichnet, dass** der Messstrom eine Amplitude zwischen der Austauschstromdichte einer Anodenreaktion und der Austauschstromdichte einer Kathodenreaktion der Brennstoffzelle(n)(5), jeweils multipliziert mit der aktiven Oberfläche der Brennstoffzelle(n) (5), aufweist.

12. Vorrichtung (30, 50, 70) nach einem der Ansprüche 7, 10 oder 11, oder Überwachungssystem (60, 80) nach einem der Ansprüche 8 bis 11,
**gekennzeichnet durch** eine Steuereinrichtung (40), die diskontinuierlich, vorzugsweise in periodischen, zeitlichen Abständen die Erzeugung des Messstromes und die Spannungsmessung auslöst.

13. Vorrichtung (30, 50, 70) nach einem der Ansprüche 7 oder 10 bis 12, oder Überwachungssystem (60, 80) nach einem der Ansprüche 8 bis 12,
**gekennzeichnet durch** einen Kurzschließer (39) zum Kurzschließen von Lastanschlüssen (20, 21) der Brennstoffzelle (5) oder des Brennstoffzellenstapels (3) während Lagerungszeiten, in denen keine Spannungsmessung erfolgt.

14. Vorrichtung (30, 50, 70) nach einem der Ansprüche 7 oder 10 bis 13, oder Überwachungssystem (60, 80) nach einem der Ansprüche 8 bis 13,
**gekennzeichnet durch** Schnittstellen zur lösbaren mechanischen Befestigung, insbesondere zum lösbaren Anschrauben oder Aufstecken, der Vorrichtung an einer Brennstoffzelle (5) oder einem Brennstoffzellenstapel (3) und zur elektrischen Kontaktierung der Messstromerzeugungseinrichtung (32, 35) und der Messeinrichtung (35, 71) mit elektrischen Lastanschlüssen (20, 21) der Brennstoffzelle (5) oder des Brennstoffzellenstapels (3).

## Claims

1. Method for monitoring a storage state of a fuel cell (5) or a stack (3) of fuel cells (5) connected electrically in series, which has/have an electrolyte (10) and the gas chambers (15, 16) of which are subjected to hydrogen during the storage, wherein the storage state is a state in which the fuel cell (15) and the fuel cells (5) are not connected to supply devices for reactants,
**characterised in that**
impedances of the fuel cell (5) or the fuel cell stack (3) are determined with at least a first and a second frequency (f1 and f2), wherein the first frequency (f1) is greater than the second frequency (f2), and wherein a moisture content of the electrolyte (10) is monitored from the determined impedance at the first frequency (f) and a hydrogen concentration in the gas chambers (15, 16) is monitored with the impedances determined at both frequencies (f1, f2), wherein an electrolyte-specific impedance increase determined at the first frequency (f1) is deducted with the impedance determined at the second frequency (f2).

2. Method according to claim 1,
**characterised in that** the first frequency (f1) lies in a frequency range of 0.9 to 1.1 kHz, preferably amounts to 1 kHz, and that the second frequency (f2) lies in a frequency range of 0.9 to 1.1 Hz, preferably 1 Hz.

3. Method according to one of the preceding claims,
**characterised in that** the impedances are measured with a current which has an amplitude which lies between the exchange current density of an anode reaction and the exchange current density of a cathode reaction of the fuel cell(s) (5), in each case multiplied by the active surface of the fuel cell(s) (5).

4. Method according to one of the preceding claims,
**characterised in that** the determination of the impedances is carried out discontinuously, preferably at periodic time intervals such as once a day, once a week or once a month.

5. Method according to one of the preceding claims,
**characterised in that** the determined impedances are compared with predetermined threshold values and an error signal is generated if one of the threshold values is exceeded or not met, preferably after repeatedly comparing the impedances with threshold values which do not result in the generation of an error signal, a life signal is generated.

6. Method according to one of the preceding claims,
**characterised in that**
the electrical load terminals (20, 21) of the fuel cell (5) or the fuel cell stack (3) are short-circuited outside of the times in which the impedances of the fuel cell(s) are determined.

7. Apparatus (30) for monitoring a storage state of a fuel cell (5) or a stack (3) of fuel cells (5) connected electrically in series, which has/have an electrolyte (10) and the gas chambers (15, 16) of which are subjected to hydrogen during the storage, wherein the storage state is a state in which the fuel cell (5) and the fuel cells (5) are not connected to supply devices for reactants,
**characterised by**
- a measuring current generation device (32) for generating a measuring current at at least a first and a second frequency (f1 and f2), wherein the first frequency (f1) is greater than the second frequency (f2),
- a measuring device (35) for measuring the voltage of the fuel cell (5) or the fuel cell stack (3) at the first and second frequency (f1 and f2),
- an impedance determination and evaluation device (36) for determining the impedances of the fuel cell (5) or the fuel cell stack (3) at the first and the second frequency (f1, f2) as a function of the measuring current and the measured voltage and for comparing the impedances with predetermined threshold values, wherein the impedance determination and evaluation device (36) is designed to monitor a moisture content of the electrolyte from the determined impedance at the first frequency (f1) and with the impedances determined at both frequencies (f1, f2) to monitor a hydrogen concentration in the gas chambers (15, 16), wherein an electrolyte-specific impedance increase determined at the first frequency (f1) is deducted with the impedance determined at the second frequency (f2) .

8. Monitoring system (60) for monitoring a storage state of a fuel cell (5) or a stack (3) of fuel cells (5) connected electrically in series, which has/have an electrolyte (10) and the gas chambers (15, 16) of which are subjected to hydrogen during the storage, wherein the storage state is a state with which the fuel cell (5) or the fuel cells (5) are not connected to supply devices for reactants, wherein the monitoring system has a monitoring device (50) comprising
- a measuring current generation device (32) for generating a measuring current at at least a first and a second frequency (f1 to f2), wherein the first frequency (f1) is greater than the second frequency (f2),
- a measuring device (35) for measuring the voltage of the fuel cell (5) or of the fuel cell stack (3) at the first and the second frequency (f1 or f2),
- an impedance determination device (51) for determining the impedance of the fuel cell (5) or the fuel cell stack (3) at the first and second frequency (f1 and f2) as a function of the measuring current and the measured voltage, and
- a transmission device (42, 43) for transmitting determined impedance values to a preferably cloud-based impedance evaluation device (52) which is spatially remote therefrom, and
- a preferably cloud-based receiving device (54) for receiving the determined impedance values and
- an impedance evaluation device (52),
which is spatially remote therefrom,
wherein the impedance evaluation device (52) is designed to compare the received impedance values with predetermined threshold values and is designed to monitor a moisture content of the electrolyte (10) with the determined impedance at the first frequency (f1) and to monitor a hydrogen concentration in the gas chambers (15, 16) with the impedances determined at both frequencies, wherein an electrolyte-specific impedance increase determined at the first frequency (f1) is deducted with the impedance determined at the second frequency (f2).

9. Monitoring system (80) for monitoring a storage state of a fuel cell (5) or a stack (3) of fuel cells (5) connected electrically in series, which has/have an electrolyte (10) and the gas chambers (15,16) of which are subjected to hydrogen during the storage, wherein the storage state is a state in which the fuel cell (5) or fuel cells (5) are not connected to supply devices for reactants, wherein the monitoring system has a monitoring device (70) comprising
- a measuring current generation device (32) for generating a measuring current at at least a first and a second frequency (f1, f2), wherein the first frequency (f1) is greater than the second frequency (f2),
- a measuring device (71) for measuring the voltage of the fuel cell (5) or the fuel cell stack (3) at the first and second frequency (f1, f2),
- a transmission device (42, 43) for transmitting measured voltage values to a preferably cloud-based impedance determination and evaluation device (72) which is spatially remote therefrom and
- a preferably cloud-based receiving device (74) for receiving the measured voltage values and
- an impedance determination and evaluation device (72), which is spatially remote therefrom,
wherein the impedance determination and evaluation device (72) is designed to determine the impedances of the fuel cell (5) or of the fuel cell stack (3) at the first and second frequency (f1 and f2) as a function of the measuring current and the measured voltage and for comparing the impedances with predetermined threshold values, and is designed to monitor a moisture content of the electrolyte (10) with the determined impedance at the first frequency (f1) and to monitor a hydrogen concentration in the gas chambers (15, 16) with the impedances determined at both frequencies (f1, f2), wherein an electrolyte-specific impedance increase determined at the first frequency (f1) is deducted with the impedance determined at the second frequency (f2).

10. Apparatus (30, 50, 70) according to claim 7 or monitoring system (60, 80) according to one of claims 8 or 9, **characterised in that** the first frequency lies in a frequency range of 0.9 to 1.1 kHz, preferably amounts to 1 kHz, and that the second frequency lies in a frequency range of 0.9 to 1.1 Hz, preferably amounts to 1 Hz.

11. Apparatus (30, 50, 70) according to claim 7 or 10, or monitoring system (60, 80) according to one of claims 8 to 10,
**characterised in that** the measuring current has an amplitude between the exchange current density of an anode reaction and the exchange current density of a cathode reaction of the fuel cell(s) (5), in each case multiplied by the active surface of the fuel cell(s) (5).

12. Apparatus (30, 50, 70) according to one of claims 7, 10 or 11, or monitoring system (60, 80) according to one of claims 8 to 11,
**characterised by** a control device (40), which triggers the generation of the measuring current and the voltage measurement discontinuously, preferably at periodic time intervals.

13. Apparatus (30, 50, 70) according to one of claims 7 or 10 to 12, or monitoring system (60, 80) according to one of claims 8 to 12,
**characterised by** a short-circuiter (39) for short-circuiting load terminals (20, 21) of the fuel cell (5) or the fuel cell stack (3) during storage times, in which no voltage is measured.

14. Apparatus (30, 50, 70) according to one of claims 7 or 10 to 13, or monitoring system (60, 80) according to one of claims 8 to 13,
**characterised by** interfaces for the detachable mechanical fastening, in particular for detachably screwing or plugging, the apparatus to a fuel cell (5) or a fuel cell stack (3) and for electrically contacting the measuring current generation device (32, 35) and the measuring device (35, 71) with electrical load terminals (20, 21) of the fuel cell (5) or the fuel cell stack (3).

## Revendications

1. Procédé de contrôle de l'état de montage d'une pile (5) à combustible ou d'un empilement (3) de piles (5) à combustible montées électriquement en série, qui a ou ont un électrolyte (10) et dont les espaces (15, 16) pour du gaz sont, pendant le montage, alimentés en hydrogène, l'état de montage étant un état dans lequel la pile (5) à combustible ou les piles (5) à combustible ne sont pas raccordées à des dispositifs d'alimentation en produits de réaction,
**caractérisé en ce que**
on détermine des impédances de la pile (5) à combustible ou de l'empilement (3) de piles à combustible à au moins une première et une deuxième fréquence (f1 et f2), la première fréquence (f1) étant plus haute que la deuxième fréquence (f2) et dans lequel, à partir de la fréquence qui a été déterminée, on détermine, pour la première fréquence (f1) une teneur en humidité de l'électrolyte (10) et on contrôle, par les impédances déterminées aux deux fréquences (f1, f2), une concentration d'hydrogène dans les espaces (15, 16) pour du gaz, une augmentation d'impédance due à l'électrolyte et déterminée à la première fréquence (f1) étant mise en déduction de l'impédance déterminée à la deuxième fréquence (f2).

2. Procédé suivant la revendication 1,
**caractérisé en ce que** la première fréquence (f1) est dans une plage de fréquence de 0,9 à 1,1 kHz, en étant de préférence de 1 kHz, et **en ce que** la deuxième fréquence (f2) est dans une plage de fréquence de 0,9 à 1,1 Hz, en étant de préférence de 1 Hz.

3. Procédé suivant l'une des revendications précédentes,
**caractérisé en ce que** l'on mesure les impédances par un courant, qui a une amplitude qui est comprise entre la densité de courant d'échange d'une réaction anodique et la densité du courant d'échange d'une réaction cathodique de la ou des piles (5) à combustible, multipliée respectivement par la surface active de la ou des piles (5) à combustible.

4. Procédé suivant l'une des revendications précédentes,
**caractérisé en ce que** la détermination des impédances s'effectue en discontinu, de préférence à des intervalles périodiques dans le temps, comme une fois par jour, une fois par semaine ou une fois par mois.

5. Procédé suivant l'une des revendications précédentes,
**caractérisé en ce que** l'on compare les impédances déterminées à des valeurs de seuil données à l'avance et on produit un signal de défaut si l'on passe au-dessus ou en dessous de l'une des valeurs de seuil, de préférence après plusieurs comparaisons des impédances à des valeurs de seuil, qui n'ont pas données une production d'un signal de défaut, on produit un signal de vie.

6. Procédé suivant l'une des revendications précédentes,
**caractérisé en ce que**, en dehors des temps dans lesquels on détermine les impédances de la ou des piles (5) à combustible, on court-circuite les bornes (20, 21) de charge électriques de la pile (5) à combustible ou de l'empilement (3) de piles à combustible.

7. Système (30) de contrôle d'un état de montage d'une pile (5) à combustible ou d'un empilement (3) de pile (5) à combustible montées en série électriquement, qui a ou ont un électrolyte (10) et dont les espaces (15, 16) pour du gaz sont, pendant le montage, alimentés en hydrogène, l'état de montage étant un état dans lequel la pile (5) à combustible ou les piles (5) à combustible ne sont pas raccordées à des dispositifs d'alimentation en produits de réaction,
**caractérisé par**
- un dispositif (32) de production de courant de mesure pour produire un courant de mesure à au moins une première et une deuxième fréquence (f1 et f2), la première fréquence (f1) étant plus haute que la deuxième fréquence (f2),
- un dispositif (35) de mesure pour mesurer la tension de la pile (5) à combustible ou de l'empilement (3) de piles à combustible à la première et à la deuxième fréquence (f1 et f2),
- un dispositif (36) de détermination et d'exploitation d'impédance pour déterminer les impédances de la pile (5) à combustible ou de l'empilement (3) de piles à combustible à la première et à la deuxième fréquence (f1, f2) en fonction du courant de mesure et de la tension mesurée et pour comparer les impédances à des valeurs de seuil données à l'avance, le dispositif (36) de détermination et d'exploitation d'impédance étant conçu pour, à partir de l'impédance déterminée à la première fréquence (f1), contrôler une teneur en humidité de l'électrolyte et, avec les impédances déterminées aux deux fréquences (f1, f2), contrôler une concentration d'hydrogène dans les espaces (15, 16) pour du gaz, une élévation d'impédance due à l'électrolyte et déterminée à la première fréquence étant mise en déduction de l'impédance déterminée à la deuxième fréquence (f2).

8. Système (60) de contrôle pour contrôler l'état de montage d'une pile (5) à combustible ou d'un empilement (3) de piles (5) à combustible montées électriquement en série, qui a ou ont un électrolyte (10) et dont les espaces (15, 16) pour du gaz sont, pendant le montage, alimentés en hydrogène, l'état de montage étant un état dans lequel la pile (5) à combustible ou les piles (5) à combustible ne sont pas raccordées à des dispositifs d'alimentation en produits de réaction, le système de contrôle comprenant un système (50) de contrôle, comprenant
- un dispositif (32) de production de courant de mesure pour produire un courant de mesure à au moins une première et une deuxième fréquence (f1 et f2), la première fréquence (f1) étant plus haute que la deuxième fréquence (f2),
- un dispositif (35) de mesure pour mesurer la tension de la pile (5) à combustible ou l'empilement (3) de piles à combustible à la première et à la deuxième fréquence (f1 et f2),
- un dispositif (51) de détermination d'impédance pour déterminer l'impédance de la pile (5) à combustible ou de l'empilement (3) de piles à combustible à la première et à la deuxième fréquence (f1 et f2) en fonction du courant de mesure et de la tension mesurée et
- un dispositif (42, 43) de transmission pour transmettre des valeurs d'impédance déterminées à un dispositif (52) d'exploitation d'impédance, qui en est éloigné dans l'espace et qui repose, de préférence, sur le cloud,
et, éloignés dans l'espace du système (50) de contrôle et reposant de préférence sur le cloud,
- un dispositif (54) de réception pour recevoir les valeurs d'impédance qui ont été déterminées et
- un dispositif (52) d'exploitation d'impédance,
le dispositif (52) d'exploitation d'impédance étant conçu pour comparer les valeurs d'impédance reçues à des valeurs de seuil données à l'avance et étant conçu pour contrôler une teneur en humidité de l'électrolyte (10) par l'impédance déterminée à la première fréquence (f1,) et pour contrôler une concentration d'hydrogène dans les espaces (15, 16) pour du gaz par les valeurs d'impédance déterminées aux deux fréquences (f1, f2), une augmentation d'impédance due à l'électrolyte et déterminée à la première fréquence (f1) étant mise en déduction de l'impédance déterminée à la deuxième fréquence (f2).

9. Système (80) de contrôle pour contrôler un état de montage d'une pile (5) à combustible ou d'un empilement (3) de piles (5) à combustible montées électriquement en série, qui a ou ont un électrolyte (10) et dont les espaces (15, 16) pour du gaz sont, pendant le montage, alimentés en hydrogène, l'état de montage étant un état dans lequel la pile (5) à combustible ou les piles (5) à combustible ne sont pas raccordées à des dispositifs d'alimentation en produits de réaction, le système de contrôle ayant un système (70) de contrôle comprenant
- un dispositif (32) de production de courant de mesure pour produire un courant de mesure à au moins une première et une deuxième fréquence (f1 et f2), la première fréquence (f1) étant plus haute que la deuxième fréquence (f2),
- un dispositif (71) de mesure pour mesurer la tension de la pile (5) à combustible ou de l'empilement (3) de pile à combustible à la première et à la deuxième fréquence (f1, f2),
- un dispositif (42, 43) de transmission pour transmettre des valeurs de tension, qui ont été mesurées, à un dispositif (72) de détermination d'impédance et d'exploitation, qui en est éloigné dans l'espace et qui repose de préférence sur le cloud,
et, éloignés dans l'espace du système (70) de contrôle et reposant de préférence sur le cloud,
- un dispositif (74) de réception pour recevoir les valeurs de tension mesurées et
- un dispositif (72) de détermination et d'exploitation d'impédance,
Le dispositif (72) de détermination et d'exploitation d'impédance étant conçu pour déterminer les impédances de la pile (5) à combustible ou de l'empilement (3) de piles à combustible à la première et à la deuxième fréquence (f1 et f2) en fonction du courant de mesure et de la tension mesurée et pour comparer les impédances à des valeurs de seuil données à l'avance et étant conçu pour contrôler la teneur en humidité de l'électrolyte (10) par l'impédance déterminée à la première fréquence (f2) et pour contrôler une concentration d'hydrogène dans les espaces (15, 16) pour du gaz, par les impédances déterminées aux deux fréquences (f1 et f2), une augmentation d'impédance due à l'électrolyte et déterminée à la première fréquence (f1) étant mise en déduction de l'impédance déterminée à la deuxième fréquence (f2).

10. Système (30, 50, 70) suivant la revendication 7 ou système (60, 80) de contrôle suivant l'une des revendications 8 ou 9, **caractérisé en ce que** la première fréquence est dans une plage de fréquence de 0,9 à 1,1 kHz, en étant de préférence de 1 kHz, et **en ce que** la deuxième fréquence (f2) est dans une plage de fréquence de 0,9 à 1,1 Hz, en étant de préférence de 1 Hz.

11. Système (30, 50, 70) suivant la revendication 7 ou 10, ou système (60, 80) de contrôle suivant l'une des revendications 8 à 10,
**caractérisé en ce que** le courant de mesure a une amplitude qui est comprise entre la densité de courant d'échange d'une réaction anodique et la densité du courant d'échange d'une réaction cathodique de la ou des piles (5) à combustible, multipliée respectivement par la surface active de la ou des piles (5) à combustible.

12. Système (30, 50, 70) suivant l'une des revendications 7, 10 ou 11, ou système (60, 80) de contrôle suivant l'une des revendications 8 à 11,
**caractérisé par** un dispositif (40) de commande, qui déclenche en discontinu, de préférence à des intervalles périodiques dans le temps, la production du courant de mesure et la mesure de la tension.

13. Système (30, 50, 70) suivant l'une des revendications 7 ou 10 à 12, ou système (60, 80) de contrôle suivant l'une des revendications 8 à 12,
**caractérisé par** un dispositif (39) de court-circuit pour court-circuiter des bornes (20, 21) de charge de la pile (5) à combustible ou de l'empilement (3) de piles à combustible pendant des temps de montage dans lesquels on n'effectue pas de mesure de tension.

14. Système (30, 50, 70) suivant l'une des revendications 7 ou 10 à 13, ou système (60, 80) de contrôle suivant l'une des revendications 8 à 13,
**caractérisé par** des interfaces pour la fixation mécanique amovible, notamment pour le vissage amovible ou l'enfichage amovible du système sur une pile (5) à combustible ou sur un empilement (3) de piles à combustible et pour mettre le dispositif (32, 35) de production de courant de mesure et le dispositif (35, 71) de mesure en contact électrique avec des bornes (20, 21) de charge électriques de la pile (5) à combustible ou de l'empilement (3) de pile à combustible.
